# FASCICULE DE BREVET EUROPEEN

(11) **EP 0 921 571 B1**
(45) Date de publication et mention de la délivrance du brevet: **14.02.2007**
(21) Numéro de dépôt: 98410124.6
(22) Date de dépôt: 23.10.1998
(51) Int. Cl.: H01L 27/08, H01L 27/02

(54) **Dispositif de protection contre des décharges électrostatiques à faible niveau de seuil**
ESD-Schutzbauteil
ESD protection device

(30) Priorité: 24.10.1997 FR 9713591
(43) Date de publication de la demande: 09.06.1999
(73) Titulaire: STMicroelectronics S.A., 92120 Montrouge (FR)
(72) Inventeur: Duclos, Franck, 37000 Tours (FR)
(74) Mandataire: de Beaumont, Michel

(56) Documents cités:
- EP-A- 0 543 742
- PATENT ABSTRACTS OF JAPAN vol. 095, no. 011, 26 décembre 1995 & JP 07 221269 A (SANYO ELECTRIC CO LTD), 18 août 1995
- PATENT ABSTRACTS OF JAPAN vol. 010, no. 005 (E-372), 10 janvier 1986 & JP 60 169110 A (TOSHIBA KK), 2 septembre 1985

## Description

La présente invention concerne un assemblage de diodes de protection à faible niveau de tension contre des décharges électrostatiques. La présente invention s'applique en particulier à la protection d'une tête de lecture de disque dur.

L'augmentation des capacités de stockage des disques durs nécessite l'utilisation de têtes de lecture magnéto-résistives de très petites dimensions. Les nouvelles têtes permettent d'atteindre des densités de stockage très élevées.

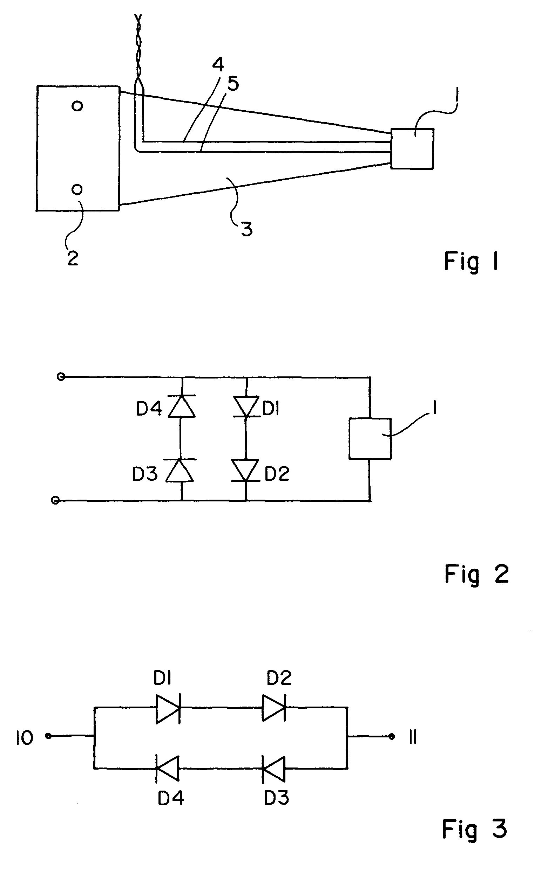

Comme l'illustre très schématiquement la figure 1, une tête de lecture magnéto-résistive (MRH) 1 est généralement reliée à un support 2 par une feuille mince de matériau flexible 3 sur laquelle sont appliqués les fils de connexions 4, 5 de la tête. La feuille flexible 3 est de très petite dimension. Elle a par exemple une longueur de l'ordre de 5 à 10 mm et une largeur de l'ordre de quelques millimètres.

Ces têtes sont destinées à être polarisées à une tension continue de l'ordre de quelque centaine de millivolts pour optimiser la réception de signaux d'amplitude très faible de l'ordre du millivolt à des fréquences supérieures à 100 MHz.

Etant donné ces très faibles valeurs de tension, ces têtes, lors de la fabrication et avant leur montage dans un circuit, sont très sensibles aux décharges électrostatiques. Il est connu que des décharges électrostatiques peuvent survenir lors de la manipulation des têtes par des outils ou à la main. Les décharges électrostatiques peuvent atteindre quelques dizaines à quelques centaines de volts et sont généralement destructives pour les têtes de lecture, d'où il résulte un rendement de fabrication et d'assemblage extrêmement faible.

Il faut donc prévoir d'associer ces têtes de lecture à une protection contre les décharges électrostatiques (ESD). La protection doit :
être bidirectionnelle car les ESD peuvent être positives ou négatives ;
présenter un seuil de tension de protection très faible ;
présenter un courant de fuite très faible pour la polarisation continue de la tête ; et
présenter une très faible capacité pour ne pas atténuer les signaux qui comme on l'a indiqué précédemment peuvent avoir une fréquence supérieure à 100 MHz.

En outre, le dispositif doit être de très petite dimension car il est souhaitable de pouvoir le monter sur la plaque flexible 3 sans augmenter sensiblement l'inertie de celle-ci.

La solution classique de protection contre des ESD à très faible tension de seuil est illustrée en figure 2. Cette solution consiste à disposer deux paires de diodes (D1-D2 ; D3-D4) en série, chacune de ces paires étant en parallèle et en opposition avec l'autre, aux bornes du dispositif 1 à protéger. Toutefois, la solution actuelle pour réaliser ce montage de quatre diodes D1 à D4 n'est pas compatible avec plusieurs des conditions nécessaires à la protection de têtes de lecture magnéto-résistives. En effet, on utilise classiquement des diodes discrètes montées chacune dans un boîtier ou ensemble dans un boîtier commun. Ceci présente l'inconvénient que le boîtier a inévitablement une dimension et un poids non négligeables.

Le brevet US 5 616 943 décrit un assemblage monolithique série/parallèle de diodes de protection.

Ainsi, un objet de la présente invention est de prévoir un dispositif de protection constitué d'un assemblage en parallèle de deux paires de diodes en série palliant tous ou au moins certains des inconvénients cités ci-dessus des solutions de l'art antérieur.

Un autre objet de la présente invention est de prévoir un tel assemblage réalisé sous forme d'une puce de silicium monolithique.

Un autre objet de la présente invention est de prévoir un tel assemblage qui présente une faible capacité.

Pour atteindre ces objets, la présente invention prévoit un assemblage de deux paires de diodes dans un substrat semiconducteur unique tel qu'énoncé en revendication 1.

Des modes de réalisation de l'invention sont mentionnés dans les revendications dépendantes.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un montage de tête magnéto-résistive de lecture de disque dur ;
la figure 2 représente un schéma classique de protection contre les décharges électrostatiques (ESD) ;
la figure 3 représente le schéma de la structure de protection contre les ESD que l'on souhaite réaliser sous forme monolithique selon la présente invention ;
les figures 4A et 4B représentent des vues en coupe d'un mode de réalisation d'une structure de protection selon la présente invention ;
la figure 4C représente une vue de dessus d'un mode de réalisation de la structure de protection selon la présente invention, les figures 4A et 4B en étant respectivement des vues en coupe selon les lignes AA et BB ; et
la figure 5 représente des courbes comparatives courant/tension de structures selon l'art antérieur et selon la présente invention.

Ainsi, la figure 3 représente la structure que la présente invention vise à réaliser sous forme monolithique. Cette structure comprend, entre deux bornes 10 et 11, une première paire de diodes en série D1, D2 d'une première polarité et une deuxième paire de diodes en série D3, D4 de polarité opposée.

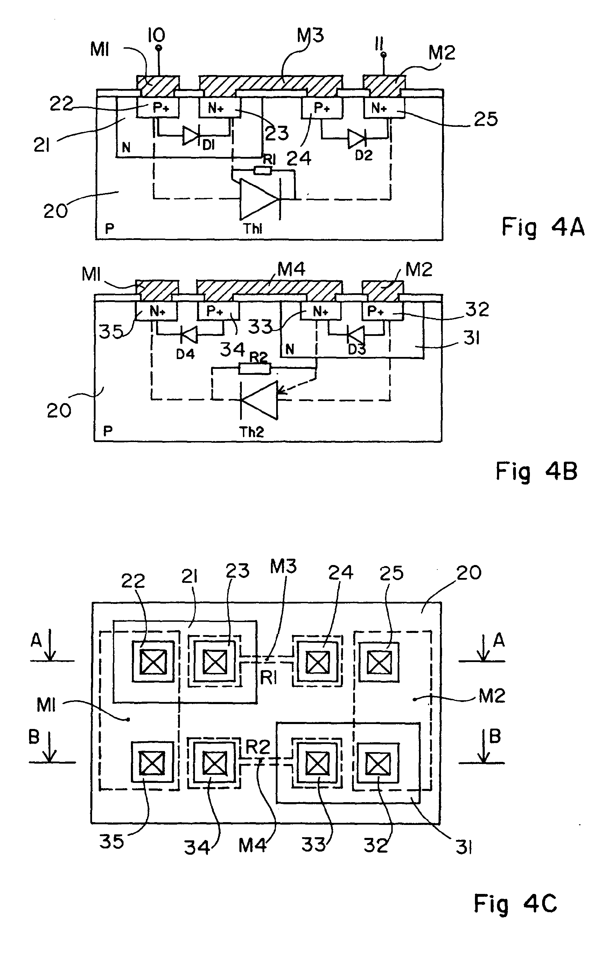

Les figures 4A, 4B, 4C représentent de façon très schématique un mode de réalisation d'une structure selon la présente invention réalisé dans un substrat de type P. La figure 4C est une vue de dessus. Les figures 4A et 4B sont respectivement une vue en coupe selon la ligne AA et une vue en coupe selon la ligne BB, c'est-à-dire représentant respectivement les diodes D1 et D2 d'une part et les diodes D3 et D4 d'autre part.

Comme le représente la figure 4A, la structure comprend un substrat 20 de type P dans lequel est formé un caisson 21 de type N faiblement dopé. La diode D1 est une diode latérale formée à partir de régions disjointes P⁺ 22 et N⁺ 23 dans le caisson 21. La diode D2 comprend des régions disjointes P⁺ 24 et N⁺ 25 formées directement dans le substrat 20.

De même, comme le représente la figure 4B, les diodes D3 et D4 sont formées à partir du même substrat 20. La diode D3 est formée dans un caisson de type N 31 et comprend des régions disjointes P⁺ 32 et N⁺ 33. La diode D4 est formée directement dans le substrat 20 et comprend des régions disjointes P⁺ 34 et N⁺ 35.

Une métallisation M1 relie les régions P⁺ 22 et N⁺ 35, et correspond à la borne 10. Cette métallisation, comme les autres métallisations de la figure 4C, repose sur une couche isolante et est en contact avec ses régions sous-jacentes aux emplacements masqués X. Une métallisation M2 relie les régions N⁺ 25 et P⁺ 32 et correspond à la borne 11. Une métallisation M3 relie les régions N⁺ 23 et P⁺ 24. Une métallisation M4 relie les régions N⁺ 33 et P⁺ 34. En d'autres termes, les métallisations M1 et M2 constituent les bornes de sortie des deux paires de diodes en parallèle et les métallisations M3 et M4 permettent de mettre en série chacune des diodes d'une paire donnée.

Dans la vue de dessus de la figure 4C, on a représenté les métallisations M3 et M4 avec une portion rétrécie entre les zones de contact. Ceci est destiné à symboliser le fait que l'on peut prévoir des résistances série, respectivement R1 et R2' entre les diodes D1 et D2 et entre les diodes D3 et D4. Ces résistances série pourraient être formées par tout moyen choisi, par exemple par des régions diffusées.

On a ainsi réalisé les quatre diodes D1 à D4 sous forme monolithique. Les régions P⁺ et N⁺ peuvent avoir de petites surfaces et en conséquence chacune des diodes aura une capacité parasite très faible, encore réduite du fait du montage en série de chacune des diodes d'une paire.

Un avantage supplémentaire de la structure illustrée en figure 4 est que chacune des paires de diodes en série est associée à une structure de thyristor parasite. Ces thyristors sont schématisés, reliés à des connexions en pointillés, en figures 4A et 4B. Le thyristor Th1 de la figure 4A a pour anode la région P⁺ 22, pour gâchette d'anode les régions N 23 et 21 et pour cathode la région N⁺ 25. Le thyristor Th2 de la figure 4B a pour anode la région P⁺ 32, pour gâchette d'anode les régions N 31 et 33 et pour cathodes la région N⁺ 35. Les résistances R1 et R2 sont disposées entre gâchette et cathode de chacun des thyristors. Dans ce montage, les thyristors parasites présentent un avantage. En effet, si un courant élevé correspondant à une décharge électrostatique (ESD) est amené à s'écouler dans les diodes D1 et D2, inévitablement, la tension aux bornes des diodes croît quand le courant qui les traverse augmente. Ici, dès que ce courant dépasse un certain seuil, le thyristor Th1 entre en conduction et la tension entre les bornes 10 et 11 chute. Le thyristor Th2 joue un rôle équivalent dans le cas d'une ESD de polarité opposée.

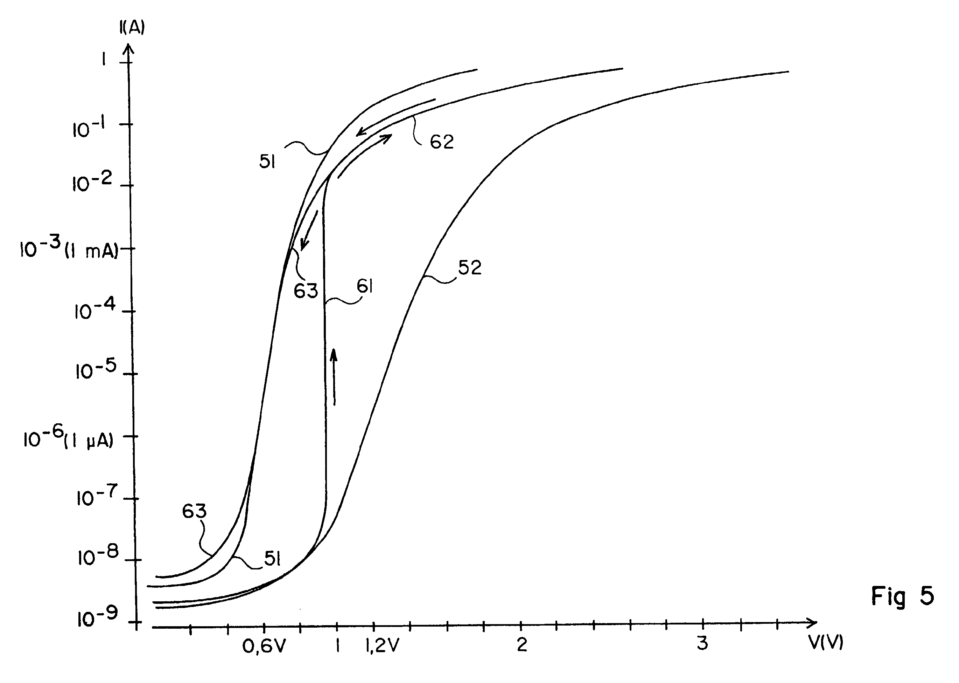

La figure 5 représente les caractéristiques statiques courant/tension résistances série d'une diode simple (courbe 51), de deux diodes discrètes en série (courbe 52) et d'un assemblage de diodes monolithiques associées à un thyristor parasite selon la présente invention (courbe 61, 62, 63). Ces courbes permettent d'estimer qualitativement l'efficacité de protection des divers dispositifs.

Pour une diode simple, comme le représente la courbe 51, le courant croît brutalement dans la diode dès que la tension aux bornes dépasse sensiblement 0,6 V, mais ensuite, dans la partie supérieure de la courbe 51, le courant croît moins rapidement et la tension aux bornes de la diode peut atteindre 2 V quand le courant atteint une valeur de l'ordre de l'ampère.

Comme on l'a exposé précédemment, on préfère selon l'art antérieur utiliser deux diodes en série plutôt qu'une diode unique pour réduire la capacité du montage. Alors, le courant commence à croître dans les diodes quand la tension atteint une valeur de l'ordre de 1,2 V. L'inconvénient de ce montage est, comme le montre la figure 5, que, quand le courant dans les diodes atteint une valeur de l'ordre de l'ampère, la tension aux bornes des diodes peut atteindre des valeurs supérieures à 3 V, ce qui peut être excessif pour la protection de dispositifs sensibles tels que des têtes de lecture magnéto-résistives de disques durs.

La courbe 61-62 représente la croissance du courant dans un dispositif selon la présente invention. On constate que le courant croît brutalement dès que la tension aux bornes des deux diodes série atteint une valeur de l'ordre du volt ce qui correspond à l'amorçage du thyristor parasite. Ensuite le dispositif présente une chute de tension nettement inférieure à celle qui apparaît pour deux diodes classiques en série (courbe 52). Les courbes 62, 63 représentent la variation de tension aux bornes du thyristor quand le courant décroît.

On notera que les courbes de la figure 5 correspondent à des simulations réalisées par la demanderesse pour des valeurs particulières des différents niveaux de dopage. De façon connue, on pourra optimiser les dopages des diverses couches pour renforcer l'efficacité du thyristor parasite et maintenir une chute de tension constante sur une plus forte plage de courant. On pourra aussi optimiser le déclenchement des thyristors parasites en jouant sur les valeurs des résistances R1, R2. L'effet thyristor pourra aussi être renforcé en formant également les diodes D2 et D4 dans des caissons N faiblement dopés.

Ainsi, le montage selon la présente invention fournit les avantages recherchés.
- Il est réalisé sous forme monolithique. Il peut donc correspondre à un composant très léger qui pourra être monté directement sur la plaque flexible de la tête de lecture. On pourra par exemple utiliser un montage à bossage dans lequel chacune des métallisations M1 et M2 est associée à un bossage conducteur de type soudure monté directement sur les fils 4, 5 de la tête de lecture (voir figure 1). On pourra également réaliser ce montage avec des fils.
- Il peut présenter une très faible capacité parasite, inférieure à 5 pF.
- Il minimise la chute de tension aux bornes du dispositif de protection quand le courant croît grâce à un effet thyristor.

Bien entendu, la présente invention est susceptible de diverses variantes et modifications qui apparaîtront à l'homme de l'art.

Selon une première variante, le montage peut être réalisé dans un substrat de type N au lieu d'un substrat de type P, tous les types de conductivité décrits précédemment étant alors inversés. En ce cas, on notera que les thyristors parasites sont des thyristors à gâchette de cathode au lieu de thyristors à gâchette d'anode.

Selon une autre variante, éventuellement combinable avec les précédentes, les métallisations M3 et M4 reliant en série chacune des paires de diodes peuvent correspondre à une unique métallisation. Toutefois, dans le cas d'une structure critique, cette variante n'est pas préférée car elle risque de réduire le gain des thyristors parasites.

## Revendications

1. Assemblage de deux paires de diodes dans un substrat semiconducteur unique (20) d'un premier type de conductivité, la première paire comprenant une première diode (D1) en série avec une deuxième diode (D2), la deuxième paire comprenant une troisième diode (D3) en série avec une quatrième diode (D4), les deux paires de diodes étant disposées en parallèle, dans lequel :
chacune des première et troisième diodes comprend des régions voisines de types de conductivité distincts formées dans un caisson faiblement dopé du second type de conductivité, ces caissons étant disjoints ;
chacune des deuxième et quatrième diodes comprend des régions disjointes de types de conductivité distincts; et
des métallisations (M1-M4) relient les électrodes des diodes pour former le montage série-parallèle recherché; **caractérisé en ce que** les deuxième et quatrième diodes sont formées directement dans le substrat.

2. Assemblage selon la revendication 1, dans lequel les liaisons entre les diodes série sont résistives.

3. Assemblage selon la revendication 1, dans lequel la métallisation (M3) reliant la première à la deuxième diode et la métallisation (M4) reliant la troisième à la quatrième diode sont reliées entre elles.

4. Assemblage selon la revendication 1, dans lequel la métallisation (M1) reliant la première à la quatrième diode et la métallisation (M2) reliant la deuxième à la troisième diode sont munies de bossage.

## Claims

1. An assembly of two pairs of diodes in a single semiconductor substrate (20) of a first type of conductivity, the first pair including a first diode (D1) in series with a second diode (D2), the second pair including a third diode (D3) in series with a fourth diode (D4), the two pairs of diodes being arranged in parallel, wherein:
each of the first and third diodes includes neighboring regions of distinct conductivity types formed in a lightly-doped well of the second conductivity type, these wells being separated;
each of the second and fourth diodes includes separated regions of distinct conductivity types; and
metallizations (M1-M4) connect the electrodes of the diodes to form the desired series-to-parallel assembly;
**characterized in that** the second and fourth diodes are formed directly in the substrate.

2. The assembly of claim 1, wherein the connections between the series diodes are resistive.

3. The assembly of claim 1, wherein the metallization (M3) connecting the first diode to the second diode and the metallization (M4) connecting the third diode to the fourth diode are interconnected.

4. The assembly of claim 1, wherein the metallization (M1) connecting the first diode to the fourth diode and the metallization (M2) connecting the second diode to the third diode are provided with bumps.

## Patentansprüche

1. Eine Anordnung aus zwei Paaren von Dioden in einem einzelnen Halbleitersubstrat (20) eines ersten Leitfähigkeitstyps, wobei das erste Paar eine erste Diode (D1) in Serie mit einer zweiten Diode (D2) umfasst, das zweite Paar eine dritte Diode (D3) in Serie mit einer vierten Diode (D4) umfasst, und wobei die Paare der Dioden parallel angeordnet sind, wobei:
jede der ersten und dritten Dioden benachbarte Regionen mit bestimmten Leitfähigkeitstypen umfassen, die in einer leicht dotierten Senke des zweiten Leitfähigkeitstyps ausgebildet sind, wobei diese Senken getrennt sind;
wobei jede der zweiten und vierten Dioden getrennte Bereiche mit bestimmten Leitfähigkeitstypen umfassen; und
wobei Metallisierungen (M1-M4) die Elektroden der Dioden verbinden, um die gewünschte serielle-zu-parallele Anordnung zu bilden;
**dadurch gekennzeichnet, dass** die zweiten und vierten Dioden direkt in dem Substrat ausgebildet sind.

2. Anordnung nach Anspruch 1, wobei die Verbindungen zwischen den seriellen Dioden einen Widerstand besitzen

3. Anordnung nach Anspruch 1, wobei die Metallisierung (M3), welche die erste Diode mit der zweiten Diode verbindet, und die Metallisierung (M4), welche die dritte Diode mit der vierten Diode verbindet, miteinander verbunden sind

4. Anordnung nach Anspruch 1, wobei die Metallisierung (M1), welche die erste Diode mit der vierten Diode verbindet, und die Metallisierung (M2), welche die zweite Diode mit der dritten Diode verbindet, mit Erhöhungen bzw. Bumps versehen sind
